# EUROPEAN PATENT APPLICATION

(11) **EP 1 575 160 A1**
(43) Date of publication of application: **14.09.2005**
(21) Application number: 05004947.7
(22) Date of filing: 07.03.2005
(51) Int. Cl.: H03D 7/14

(54) **Mixer circuit and receiver circuit using the same**

(30) Priority: 08.03.2004 JP 2004063541
(71) Applicant: MATSUSHITA ELECTRIC INDUSTRIAL CO., LTD., Osaka 571-8501 (JP)
(72) Inventor: Hamasaki, Toshinori, Tokyo 145-0062 (JP); Ishida, Kaoru, Osaka 575-0045 (JP)
(74) Representative: TBK-Patent

(57) **Abstract**

A mixer circuit is provided with a quadrature demodulator including a Gilbert cell in which a first differential amplifier and a switching circuit are vertically stacked for connection and a bypass circuit including a second differential amplifier having a pair of differential input terminals short-circuited with each other, and provided in parallel with the first differential amplifier. Correction of a DC offset is performed by inactivating the first differential amplifier and activating the second differential amplifier, and detecting the DC offset under such state.

## Description

### BACKGROUND OF THE INVENTION

### 1. Field of the Invention

The present invention relates to a direct conversion receiver circuit, and to a mixer circuit to be used therein. The mixer circuit includes a quadrature demodulator constituted of a Gilbert cell. The present invention also relates to a method of correcting a DC offset utilizing the receiver circuit or mixer circuit. To be more specific, the present invention relates to a circuit configuration of the receiver circuit or the mixer circuit, and a method of correcting a DC offset therein, that can suppress a variation of the DC offset of the quadrature demodulator between during a normal operating and during a DC offset correction.

### 2. Prior Art

The recent reduction in size of mobile phones has urged the development of a direct conversion integrated receiver circuit, which can save the number of peripheral devices such as a filter. Under the direct conversion system, a high frequency signal is directly converted into a baseband signal. Accordingly, the signal to be handled is given a low frequency within the baseband range, which allows integrating the filter. Besides, a filter for an intermediate frequency range used in the current superheterodyne system can be omitted, which allows further reduction in size.

However, since the direct conversion system does not include an intermediate frequency amplifier, a higher amplification factor is required in the high frequency range and the baseband range, in comparison with the superheterodyne system. This leads to a drawback that a DC offset generated in the quadrature demodulator and the baseband amplifier has to be corrected, so as to prevent the saturation of the amplifier.

Here, JP-A Laid Open No.2002-217769 proposes to inactivate the high frequency amplifier and suspend outputting of a signal, so that the quadrature demodulator and the baseband amplifier do not receive any input, when performing the DC off set correction. Concurrently a dummy high frequency amplifier is activated so as to keep the input condition of the quadrature demodulator from changing, and to thereby suppress a variation of the DC offset in the quadrature demodulator, between a normal operation and the DC offset correction.

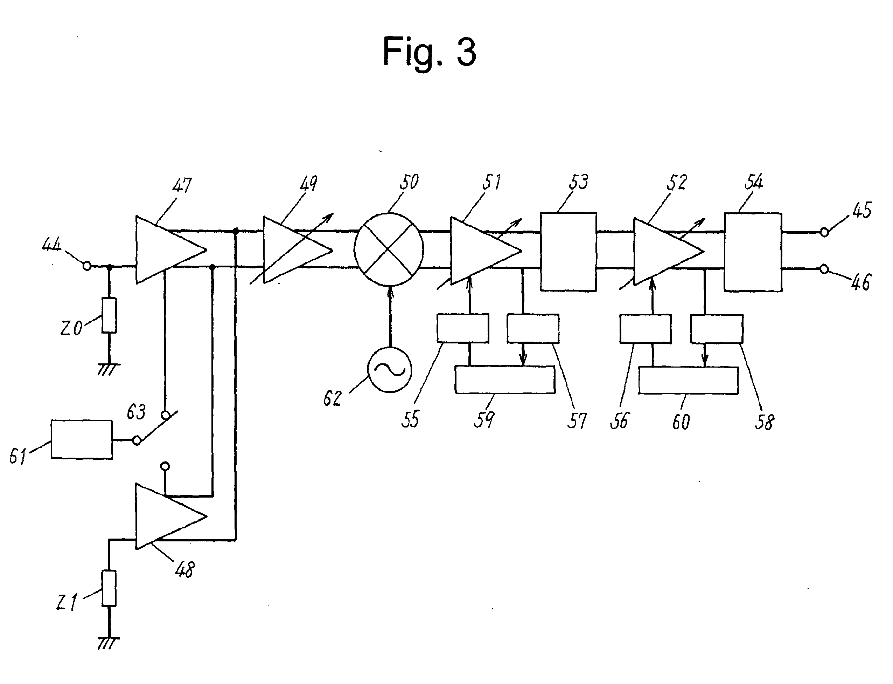

Referring to Fig. 3, description will be given on a method of suppressing a variation of the DC offset in the quadrature demodulator, between the DC offset in a normal operation and that during the DC offset correction, according to the cited document.

Fig. 3 is a block diagram showing a receiver circuit that suppresses a variation of the DC offset in the quadrature demodulator, between a normal operation and the DC offset correction. In the receiver circuit shown, a high frequency signal received and input via a high frequency signal input terminal 44 is amplified by a first low-noise amplifier (hereinafter, LNA) 47, and further amplified by a third LNA 49. An input of the first LNA 47 is grounded via an impedance Z0. An output of the third LNA 49 is input to a quadrature demodulator 50, to be converted into a baseband signal by frequency-mixing with an output of a local oscillator 62. An output of the quadrature demodulator 50 is input to a first variable gain amplifier (hereinafter, VGA) to be amplified, and input to a first low-pass filter (hereinafter, LPF) 53 for removal of an unnecessary signal. An output of the first LPF 53 is input to a second VGA for amplification and to a second LPF for removal of an unnecessary signal, thus to be output from a signal output terminal 45 and a negative phase signal output terminal 46.

When the level of the received signal changes, the gain of the third LNA, the first VGA and the second VGA are changed, such that the signal output level at the signal output terminal 45 and the negative phase signal output terminal 46 is controlled to be within a predetermined range.

During such operation, normally a DC offset takes place in an amplifier. In a VGA especially, the DC offset at the output terminal varies according to the gain setting of the VGA. The DC offset in the output of the third LNA 49 is not a problem since the following quadrature demodulator 50 converts the frequency. However, in a direct conversion receiver circuit, an oscillating frequency of the local oscillating circuit is identical with that of an input signal. Accordingly, in the event that the local oscillator signal from the local oscillating circuit 62 leaks to the input interface of the third LNA 49 for some reason, such signal is output from the quadrature demodulator 50 as a DC offset. Consequently, changing the gain setting of the third LNA 49 results in a variation of the DC offset in the output of the quadrature demodulator 50.

Therefore, when the gain setting of the VGA is changed, it is necessary to correct the DC offset. Especially in the direct conversion receiver circuit, since the amplification factor in the baseband range is large, the circuit becomes saturated with the DC offset and unable to operate normally, unless the DC offset is corrected.

The cited document describes the following process for the DC offset correction. Firstly, the first LNA 47 is inactivated so as to suspend outputting a signal. A first AD converter 57 is employed for monitoring an output DC offset of the first VGA 51. Based on the monitoring result on the output DC offset by the first AD converter 57, a first control circuit 59 is employed to control the first DA converter 55, so as to adjust an amount of the DC offset to be added to the input to the first VGA 51. Thus controlling the DC offset to be added to the input to the first VGA 51 based on the monitoring result on the output DC offset allows correcting the output DC offset of the first VGA 51.

In the case where the first LNA 47 is not inactivated, and hence a high frequency signal is not stopped, the output of the first VGA includes the DC offset and the high frequency signal superimposed thereon. As a result, a DC offset correction is performed such that the output becomes zero, with respect to the sum of the signal and the DC offset at the time of monitoring the output DC offset of the first VGA 51. Accordingly, the DC offset remains as it is when an input is not received, thus resulting in an erroneous DC offset correction.

Therefore, when correcting the DC offset, the amplifier to be corrected has to be kept from a signal input. This leads to a change of the input condition to the third LNA 49 when a direction of a bias voltage of a bias circuit 61 is changed by a switch 63 so as to inactivate the first LNA 47 and to stop the signal, and such change results in a change in DC offset in the quadrature demodulator 50 with respect to the DC offset at a normal operation, because of a signal that has leaked from the local oscillating circuit 62 to the input to the third LNA 49.

In order to avoid such problem, the cited document discloses connecting in parallel with the first LNA 47 a second LNA 48 as dummy, the input to which is grounded via an impedance Z1, and hence to which a high frequency signal is not input. During a DC offset correction, the switch 63 is turned so that the bias circuit 61 inactivates the first LNA 47 but activates the second LNA 48. This allows maintaining the input condition of the third LNA 49 unchanged, thereby keeping the DC offset of the quadrature demodulator 50 constant (identical), irrespective of whether during a normal operation or DC offset correction.

### [Patented document 1] JP-A Laid Open No.2002-217769

The output DC offset in the second VGA 52 can also be corrected as with the DC offset correction of the first VGA 51, utilizing a second AD converter 58, a second control circuit 60 and a second DA converter 56.

However, providing a dummy high frequency amplifier incurs a disadvantage of an increase in circuit scale as well as in the number of peripheral parts.

### SUMMARY OF THE INVENTION

Accordingly, it is an object of the present invention to provide a mixer circuit and a receiver circuit, capable of suppressing a variation of the DC offset of the quadrature demodulator between during a normal operation and during a DC offset correction, to thereby perform an accurate DC offset correction without increasing the circuit scale or the number of peripheral parts, as well as a method of DC offset correction to be performed in such circuit.

The present invention provides a mixer circuit, comprising a quadrature demodulator including a Gilbert cell in which a first differential amplifier and a switching circuit are vertically stacked for connection; and a bypass circuit including a second differential amplifier having a pair of differential input terminals short-circuited with each other, and provided in parallel with the first differential amplifier.

In the circuit thus configured, the bypass circuit, including the second differential amplifier having a pair of differential input terminals short-circuited with each other, and provided in parallel with the first differential amplifier, inactivates the first differential amplifier and activates the second differential amplifier during a DC offset correction. Accordingly, the quadrature demodulator can operate under unchanged conditions and without receiving a signal input, during the DC offset correction. This results in suppressing a variation of the DC offset of the quadrature demodulator between during a normal operation and during a DC offset correction, and thus performing an accurate DC offset correction. Besides, since all that is necessary is adding the second differential amplifier, the variation of the DC offset of the quadrature demodulator between during a normal operation and during a DC offset correction can be suppressed without increasing the circuit scale or the number of peripheral parts.

A receiver circuit according to the present invention comprises the mixer circuit provided with the quadrature demodulator including the Gilbert cell in which the first differential amplifier and the switching circuit are vertically stacked for connection, and the bypass circuit including the second differential amplifier having the differential input terminals thereof short-circuited with each other, and provided in parallel with the first differential amplifier; and a variable gain amplifier that includes a DC offset canceling function and amplifies an output of the mixer circuit.

In the circuit thus configured, the bypass circuit, including the second differential amplifier having a pair of differential input terminals short-circuited with each other, and provided in parallel with the first differential amplifier, inactivates the first differential amplifier and activates the second differential amplifier during a DC offset correction. Accordingly, the quadrature demodulator can operate under unchanged conditions and without receiving a signal input, during the DC offset correction. This results in suppressing a variation of the DC offset of the quadrature demodulator between during a normal operation and during a DC offset correction, and thus performing an accurate DC offset correction. Besides, since all that is necessary is adding the second differential amplifier, the variation of the DC offset of the quadrature demodulator between during a normal operation and during a DC offset correction can be suppressed without increasing the circuit scale or the number of peripheral parts.

The first differential amplifier amplifies a first differential signal including a first and a second signal, to thereby output a third and a fourth signal.

The switching circuit includes a first, a second, a third and a fourth transistor. In the first transistor, the third signal is input to the emitter, and a fifth signal, out of the second differential signal including the fifth and a sixth signal, is input to the base. In the second transistor, the third signal is input to the emitter, and the sixth signal is input to the base. In the third transistor, the fourth signal is input to the emitter and the sixth signal is input to the base, and the collector is connected in common with the collector of the first transistor, so as to serve as a first output terminal. In the fourth transistor, the fourth signal is input to the emitter and the fifth signal is input to the base, and the collector is connected in common with the collector of the second transistor, so as to serve as a second output terminal.

Under such configuration, the switching circuit utilizes the first to the fourth transistors to output the third signal to either of the first output terminal or the second output terminal by switching according to a magnitude of the fifth and the sixth signal, and to output the fourth signal to either of the first output terminal or the second output terminal by oppositely switching according to a magnitude of the fifth and the sixth signal.

Here, the first differential signal is the high frequency signal, and the second differential signal is the local oscillator signal.

A first method of correcting a DC offset according to the present invention employs the mixer circuit according to the present invention for the correction of the DC offset, comprising inactivating the first differential amplifier and activating the second differential amplifier, and detecting the DC offset under such state and performing the correction.

A second method of correcting a DC offset according to the present invention employs the receiver circuit according to the present invention for the correction of the DC offset, comprising inactivating the first differential amplifier and activating the second differential amplifier, and detecting the DC offset under such state and performing the correction.

By the first and the second method thus arranged, the mixer circuit or the receiver circuit provided with the bypass circuit including the second differential amplifier is employed, such that the first differential amplifier is inactivated while the second differential amplifier is activated, and the DC offset is detected and corrected under such state. Such method allows suppressing a variation of the DC offset of the quadrature demodulator between during a normal operation and during a DC offset correction, to thereby perform an accurate DC offset correction without increasing the circuit scale or the number of peripheral parts.

As described above, the mixer circuit and the receiver circuit, as well as the method of correcting the DC offset, allow suppressing a variation of the DC offset of the quadrature demodulator between during a normal operation and during a DC offset correction, to thereby perform an accurate DC offset correction without increasing the circuit scale or the number of peripheral parts.

### BRIEF DESCRIPTION OF THE DRAWINGS

Fig. 1 is a circuit diagram showing a configuration of a mixer circuit according to a first embodiment of the present invention;
Fig. 2 is a block diagram showing a configuration of a receiver circuit according to the first embodiment of the present invention; and
Fig. 3 is a block diagram showing a configuration of an existing receiver circuit.

### DESCRIPTIONS OF THE PREFERRED EMBODIMENTS

### First Embodiment

Referring to the drawings, a receiver circuit according to a first embodiment of the present invention will be described hereunder.

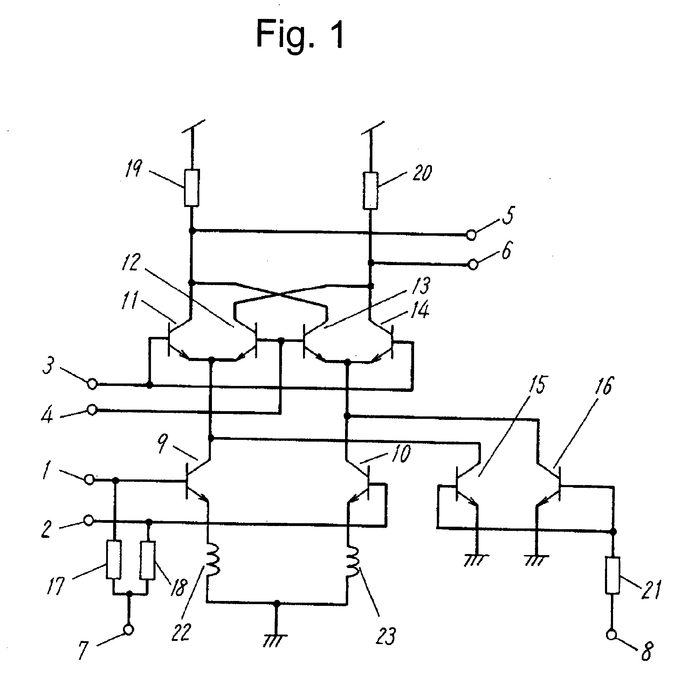

Fig. 1 is a circuit diagram showing a configuration of the mixer circuit according to the first embodiment of the present invention. The mixer circuit includes a quadrature demodulator constituted of a Gilbert cell, and a bypass circuit. A high frequency signal is input via a high frequency signal input terminal 1 and a negative-phase high frequency signal input terminal 2. The high frequency signal is amplified by a differential amplifier including a first transistor 9 and a second transistor 10. A first inductor 22 and a second inductor 23 are located between emitters of the first transistor 9 and the second transistor 10, to determine a gain.

The high frequency signal amplified by the differential amplifier is input to a switching circuit including a third transistor 11, a fourth transistor 12, a fifth transistor 13 and a sixth transistor 14. Then the high frequency signal is converted into a baseband signal by frequency mixing with a local oscillator signal input via a local oscillation input terminal 3 and a negative-phase local oscillation input terminal 4. A third resistance 19 and a fourth resistance 20 are load resistances.

The frequency-mixed signal is output from a signal output terminal 5 and a negative-phase signal output terminal 6. To a first switch control input terminal 7, a predetermined voltage is applied when activating the quadrature demodulator, while a zero potential is applied when inactivating the quadrature demodulator. To a second switch control input terminal 8, a predetermined voltage is applied when inactivating the quadrature demodulator, while a zero potential is applied when activating the quadrature demodulator.

The voltage applied to the first switch control input terminal 7 is added to the base of the first transistor 9 and the second transistor 10, via the first resistance 17 and the second resistance 18. The voltage applied to the second switch control input terminal 8 is added to the base of the seventh transistor 15 and the eighth transistor 16, via a fifth resistance 21. The emitter of the seventh transistor 15 and the eighth transistor 16 are grounded, and a collector thereof is respectively connected to the collector of the first transistor 9 and the second transistor 10, thus to constitute the bypass circuit. It is preferable that the seventh transistor 15 and the eighth transistor 16 have the same characteristics as those of the first transistor 9 and the second transistor 10.

The base of the seventh transistor 15 and the eighth transistor 16 are connected in common to the fifth resistance 21. Accordingly, a pair of differential input terminals of a differential amplifier including the seventh transistor 15 and the eighth transistor 16 are short circuited with each other, so as not to receive any signal input. Such configuration eliminates the need to insert an inductor corresponding to the first inductor 22 and the second inductor 23 employed for determining a gain during a normal operation, thereby achieving reduction of components, or reduction of a chip footprint from a viewpoint of integration level.

In such circuit, when a positive voltage is applied to the first switch control signal input to the first switch control input terminal 7, and a zero voltage is applied to the second switch control signal input to the second switch control input terminal 8, a current runs through the first transistor 9 and the second transistor 10, but does not run through the seventh transistor 15 and the eighth transistor 16. Accordingly, the quadrature demodulator is activated and performs a normal operation.

By contrast, when a zero voltage is applied to the first switch control signal input to the first switch control input terminal 7, and a positive voltage is applied to the second switch control signal input to the second switch control input terminal 8, a current does not run through the first transistor 9 and the second transistor 10, but runs through the seventh transistor 15 and the eighth transistor 16. Accordingly, the quadrature demodulator is inactivated.

Despite the quadrature demodulator is inactivated, the current is being supplied to the seventh transistor 15 and the eighth transistor 16, and the switching circuit including the third transistor 11, the fourth transistor 12, the fifth transistor 13 and the sixth transistor 14 is also operating normally. Accordingly, the output of the quadrature demodulator includes a DC offset as under the activated state.

Consequently, employing the mixer circuit according to the first embodiment of the present invention enables generating the same DC offset as under the activated state even when the quadrature demodulator is inactivated during a DC offset correction, and thereby performing an accurate DC offset correction involving the quadrature demodulator.

Also, the mixer circuit according to the first embodiment of the present invention is different from an existing quadrature demodulator only in that the seventh transistor 15, the eighth transistor 16 and the fifth resistance 21 are additionally provided. Therefore, just adding a minimal number of devices allows suppressing a variation of the DC offset.

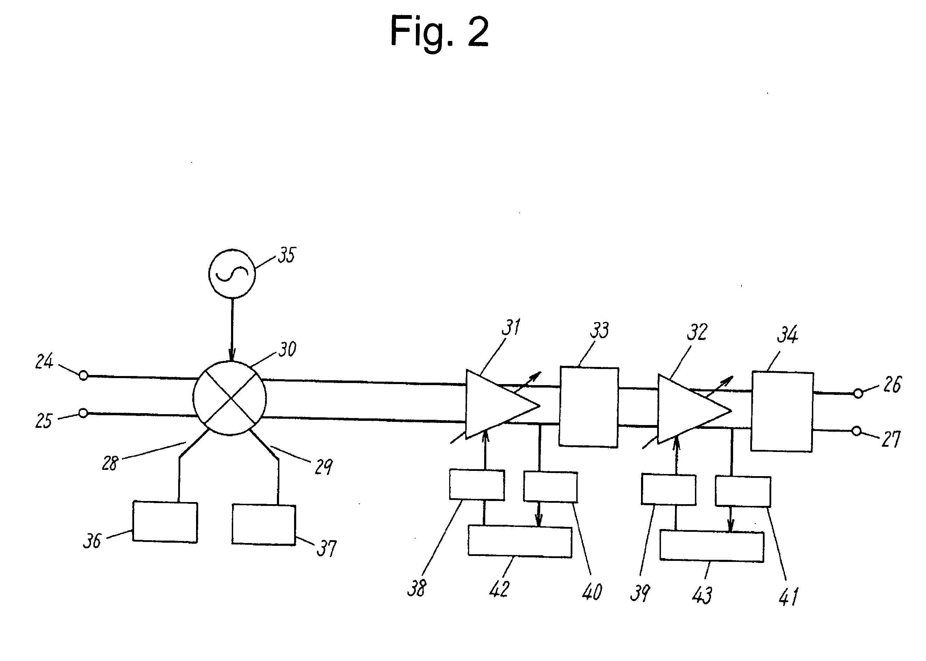

Referring now to Fig. 2, overall description on the receiver circuit will be given hereunder. A high frequency signal is input to a quadrature demodulator 30 via a high frequency signal input terminal 24 and a negative-phase high frequency signal input terminal 25. The high frequency signal input to the quadrature demodulator 30 is converted into a baseband signal by frequency mixing with a local oscillator signal of a local oscillator circuit 35, and output from the quadrature demodulator 30. Such output of the quadrature demodulator 30 is input to a first VGA 31, and then to a first LPF 33 for removal of an unnecessary signal. The output of the first LPF 33 is input to a second VGA 32 and then to a second LPF 34 for removal of an unnecessary signal, to be thereafter output from a signal output terminal 26 and a negative-phase signal output terminal 27.

It is to be noted that in Fig. 2 the constituents corresponding to the first LNA 47 and the third LNA 49 shown in Fig. 3 are not shown.

During a normal operation when the DC offset correction is not performed, a first bias circuit 36 outputs a positive voltage, and a second bias circuit 37 outputs a zero voltage. The output of the first bias circuit 36 corresponds to the input to the first switch control input terminal 7 of Fig. 1, while the output of the second bias circuit 37 corresponds to the input to the second switch control input terminal 8 of Fig. 1. Accordingly, the quadrature demodulator 30 is activated and performs a normal operation, as stated referring to Fig. 1.

When performing the DC offset correction, the first bias circuit 36 outputs a zero voltage, and a second bias circuit 37 outputs a positive voltage. Accordingly, the quadrature demodulator 30 is inactivated as stated referring to Fig. 1. The DC offset generated in the quadrature demodulator at this moment is the same as that of the normal operating state, which can be accurately corrected by the first VGA 31 disposed at a posterior stage for the DC offset correction.

Steps of the DC offset correction with respect to the output of the first VGA 31,32 is similar to those described referring to Fig. 1. In Fig. 2, the numerals 40, 41 represent an AD converter, and 42, 43 a control circuit, respectively.

### Industrial Applicability

As described above, the present invention can be advantageously applied to a technique of suppressing a variation of a DC offset in a quadrature demodulator between during a normal operation and during the DC offset correction, in a direct conversion receiver circuit.

A mixer circuit is provided with a quadrature demodulator including a Gilbert cell in which a first differential amplifier and a switching circuit are vertically stacked for connection and a bypass circuit including a second differential amplifier having a pair of differential input terminals short-circuited with each other, and provided in parallel with the first differential amplifier. Correction of a DC offset is performed by inactivating the first differential amplifier and activating the second differential amplifier, and detecting the DC offset under such state.

## Claims

1. A mixer circuit, comprising:
a quadrature demodulator including a Gilbert cell in which a first differential amplifier and a switching circuit are vertically stacked for connection; and
a bypass circuit including a second differential amplifier having a pair of differential input terminals short-circuited with each other, and provided in parallel with the first differential amplifier.

2. The mixer circuit according to claim 1,
wherein the first differential amplifier amplifies a first differential signal including a first and a second signal, to thereby output a third and a fourth signal;
the switching circuit including:
a first transistor to an emitter of which the third signal is input, and to a base of which a fifth signal out of a second differential signal including the fifth and a sixth signal;
a second transistor to an emitter of which the third signal is input and to a base of which the sixth signal is input;
a third transistor to an emitter of which the fourth signal is input, to a base of which the sixth signal is input, and a collector of which is connected in common with a collector of the first transistor so as to serve as a first output terminal; and
a fourth transistor to an emitter of which the fourth signal is input, to a base of which the fifth signal is input, and a collector of which is connected in common with a collector of the second transistor so as to serve as a second output terminal;
the switching circuit outputs the third signal to either of the first output terminal or the second output terminal by switching according to a magnitude of the fifth and the sixth signal, and outputs the fourth signal to either of the first output terminal or the second output terminal by oppositely switching according to a magnitude of the fifth and the sixth signal.

3. The mixer circuit according to claim 2, wherein the first differential signal is the high frequency signal, and the second differential signal is the local oscillator signal.

4. A receiver circuit, comprising:
the mixer circuit according to one of claims 1 to 3; and
a variable gain amplifier that includes a DC offset canceling function and amplifies an output of the mixer circuit.

5. A method of correcting a DC offset utilizing the mixer circuit according to one of claims 1 to 3, comprising:
inactivating the first differential amplifier and activating the second differential amplifier, and
detecting the DC offset under such state and performing the correction.

6. A method of correcting a DC offset utilizing the receiver circuit according to claim 4, comprising:
inactivating the first differential amplifier and activating the second differential amplifier, and
detecting the DC offset under such state and performing the correction.
